# EUROPEAN PATENT APPLICATION

(11) **EP 1 349 196 A2**
(43) Date of publication of application: **01.10.2003**
(21) Application number: 03100774.3
(22) Date of filing: 25.03.2003
(51) Int. Cl.: H01J 37/32

(54) **Plasma etching method and apparatus for manufacturing a semiconductor device**

(30) Priority: 25.03.2002 KR 2002016148; 08.07.2002 KR 2002039468; 13.08.2002 KR 2002047888; 14.11.2002 KR 2002070648
(71) Applicant: Adaptive Plasma Technology Corporation, Suwon-city, Kyungki-do (KR)
(72) Inventor: Kim, Nam Hun, Paldal-gu, Suwon-City, Kyungki-do (KR)
(74) Representative: Stanley, David William

(57) **Abstract**

A plasma etching apparatus includes a CCD (101), a light component extractor (102), a K estimator (103), a comparator (104), a memory (105), a controller (106), a gas supplier (107), and a timer (108). The plasma etching apparatus also includes: a chamber (61c) in which a wafer (63c) to be etched is loaded; a first dome (62c) sealing an upper end of the chamber (61c); a coil (64c) wound on the dome (62c) to generate an electric field into the chamber (61c); at least one light emission tip (66) disposed through a predetermined portion of the dome (62c), so as to emit light toward the wafer (63c) and receive light reflected by the wafer (63c); and a plurality of nozzles (67,68), each of which is disposed around the light emission tip (66) and through the predetermined portion of the dome (62c), so as to supply gases into the chamber (61c).

## Description

The present invention relates to plasma etching methods and apparatus for manufacturing a semiconductor device.

Etching signifies a process of eliminating an unnecessary portion from a silicon wafer by utilizing chemicals or gas in a process of manufacturing a semiconductor device. Further, a proportion between etched rates of different thin films under the same plasma condition is called "etching selectivity".

Conventionally, wet etching in which chemicals are utilized has been mainly used, and dry etching is now becoming more widely used resulting from a trend in which circuit patterns become more delicate and precise. Dry etching is an etching which does not utilize a chemical solution but an activated gas or plasma.

In wet etching, isotropic etching is carried out due to chemical action by strong acid, so that even a portion covered by a mask may be etched. In contrast, dry etching utilizes reactive ion etching, in which activated chemical gas such as halide is employed in a plasma state and ions in the plasma perform the etching. Therefore, dry etching can realize anisotropic etching in which etching is carried out only in the vertical direction on a substrate, so that dry etching is suitable in processes requiring high precision and fineness, for example, in processing a Very Large Scale Integrated circuit (VLSI).

Examples of known etching techniques will now be described, with reference to Figures 1 to 4 of the accompanying diagrammatic drawings, in which:
Figures 1A and 1B are sectional views of chambers employed in a conventional plasma etching apparatus utilizing an ICP method;
Figures 2A and 2B are plan views of coils shown in Figures 1A and 1B;
Figure 3 is a sectional view of a chamber of a conventional plasma etching apparatus employed in a conventional CCP etching method; and
Figure 4 is a view including a diagram, which shows a construction of a conventional plasma etching apparatus.

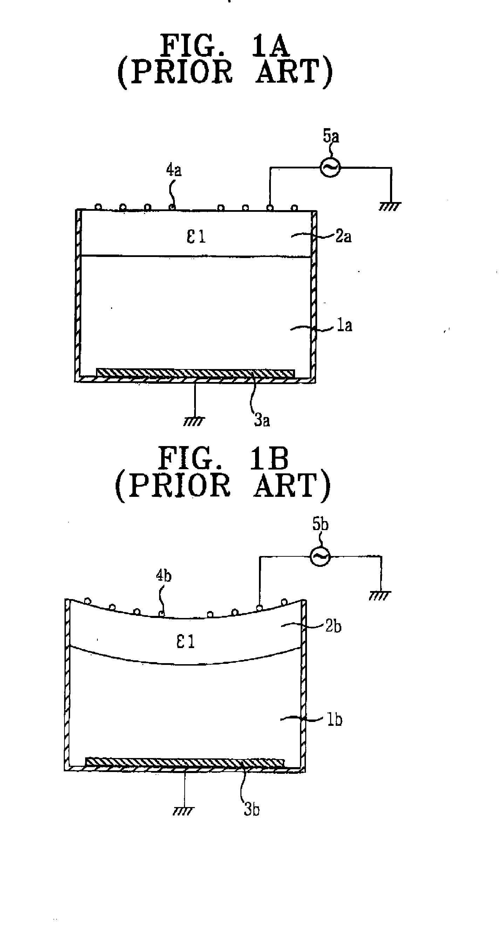

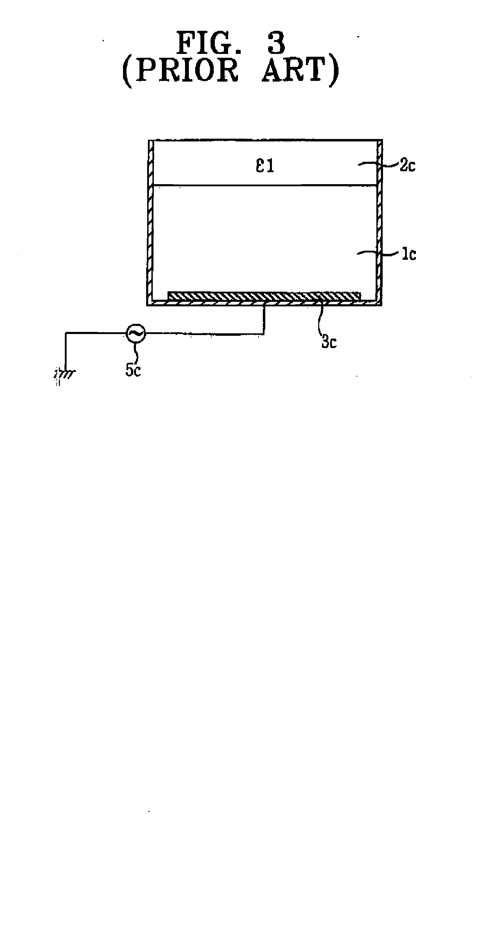

According to ways of creating the plasma, conventional plasma etching can be classified into Inductive Coupled Plasma (ICP) etching as shown in Figures 1A and 1B and Capacitive Coupled Plasma (CCP) etching as shown in Figure 3.

Figures 1A and 1B are sectional views of chambers of plasma etching apparatuses employed in conventional ICP etching methods. In this case, Figure 1A shows a chamber 1a including a dome 2a having a flat shape, and Figure 1B shows a chamber 1b sealed by a dome 2b having a concave shape.

As shown in Figures 1A and 1B, each of the conventional ICP etching apparatuses includes a chamber 1a or 1b, a dome 2a or 2b, a wafer 3a or 3b, a coil 4a or 4b, and an inductive power supply section 5a or 5b.

Hereinafter, the plasma etching apparatus shown in Figure 1A will be described as an example for the convenience of description.

Inner surfaces of the chamber 1a are formed of an aluminum layer coated with oxide, and a wafer is placed and etched in the chamber 1a.

The dome 2a is a member for sealing the chamber 1a and can be classified into a flat shape as shown in Figure 1A and a concave (or convex) shape as shown in Figure 1B. The dome 2a is made from alumina Al₂O₃ having a dielectric constant ε1 ranging between 9.3 and 9.8.

The coil 4a is disposed on the dome 2a. The coil 4a receives electric current from the inductive power supply section 5a (also called "a power source"), so as to generate an electric field.

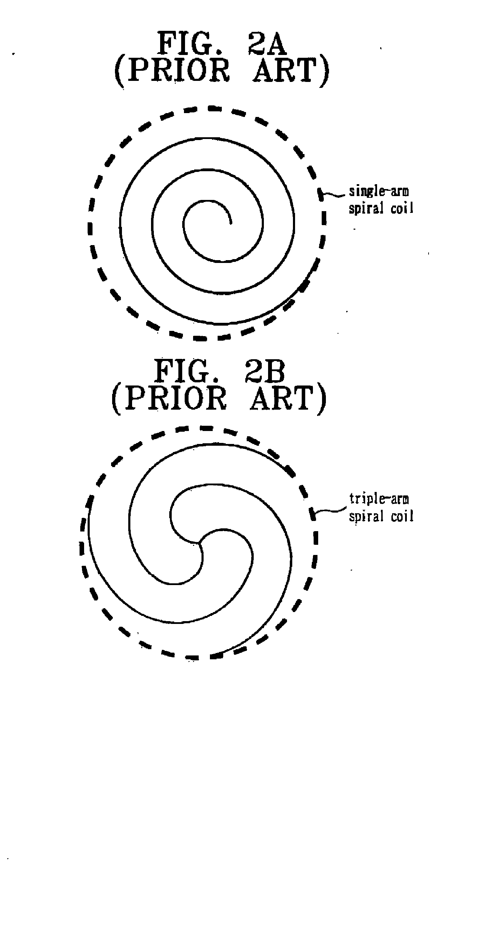

As shown in Figures 2A and 2B, the coil 4a may have a single-arm or triple-arm spiral shape. The coil 4a has a flat shape in the case of the single-arm spiral coil, while it has a convex shape in which its central portion is convex upward or downward in the case of the triple-arm spiral coil.

Therefore, the electric field generated by the coil 4a is introduced into the chamber 1a through the dome 2a having the predetermined dielectric constant ε1.

Therefore, the electric field introduced in this way discharges the gas contained in the chamber 1a, thereby making the gas enter a plasma state, so that an unmasking portion of a surface of the wafer 3a is etched by chemical reactions between charged ions and neutral radical particles produced by the plasma.

In this case, the electric field has an intensity stronger at a central portion of the wafer 3a than that at an edge portion of the wafer 3a due to the arrangement of the coil 4a. As a result, uniformity of the etch rate is not secured, since a density of the plasma produced in the chamber 1a is in proportion to the intensity of the electric field.

Therefore, in order to secure uniformity of the etch rate, a plasma etching apparatus capable of uniformly maintaining the density of plasma in the chamber 1a has been required.

For reference, inductive electric power applied to the coil 4a by the inductive power supply section 5a has a value ranging between 200 and 1500 W in the case of poly-etching while having a value smaller than 2000 W in the case of oxide-etching, the wafer 3a having a size of eight inches in both cases.

When the inductive power supply section 5a applies a high inductive electric power of 1500 W, an electric power applied to the single coil shown in Figure 2A is 1500 W, and an electric power applied to the triple coil shown in Figure 2B is 500 W.

However, in the conventional coil 4a having the construction described above, an arc discharge is generated at an end portion, that is, at a grounded portion of the coil 4a.

Figure 3 is a sectional view of a chamber of a conventional plasma etching apparatus employed in a conventional CCP etching method.

In a chamber 1c of the conventional plasma etching apparatus employed in the conventional CCP etching method, inner surfaces of the chamber 1c are formed of an aluminum layer coated with oxide, and a wafer 3c is seated on an inner bottom surface of the chamber 1c. Further, a single-layer dome 2c having a predetermined dielectric constant ε1 is disposed at an upper end of the chamber 1c, thereby sealing the chamber 1c. Also, the plasma etching apparatus further includes a bias power supply section 5c which supplies a bias electric power of 90 to 100 W, thereby increasing ion energy in the chamber 1c.

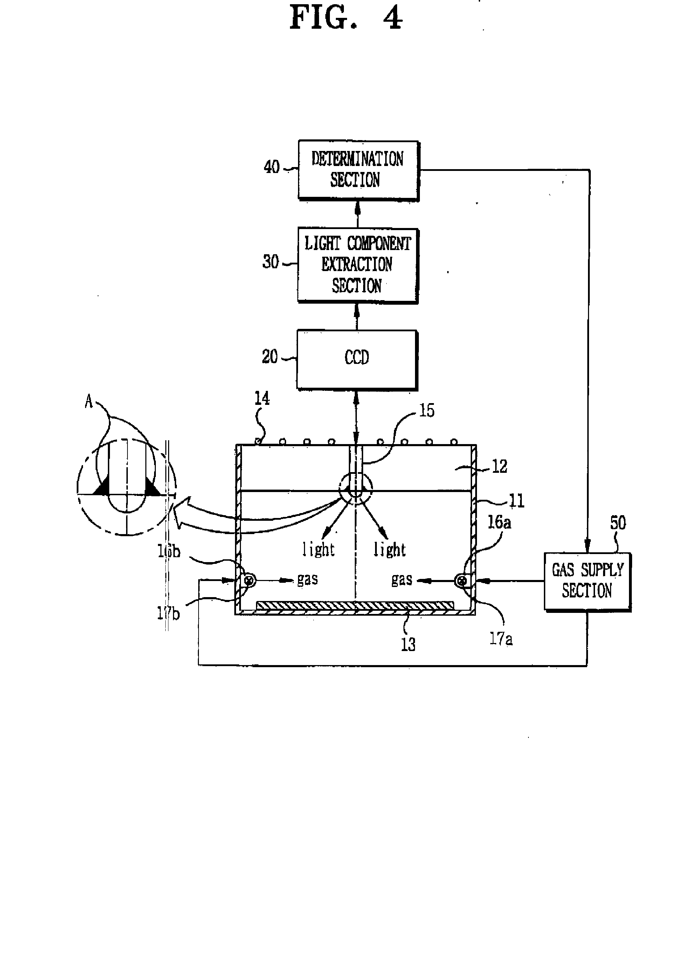

Figure 4 is a diagram showing a construction of a conventional plasma etching apparatus.

As shown in Figure 4, the conventional plasma etching apparatus includes a chamber 11, a charge coupled device (hereinafter, referred to as "CCD") 20, a light component extraction section 30, a determination section 40, and a gas supply section 50.

A dome 12 is disposed at an upper end of the chamber 11, so as to seal the chamber 11. A light emission tip 15 extends through a central portion of the dome 12 toward an interior of the chamber 11. Further, nozzles 16a and 16b are disposed at lower portions of inner side surfaces of the chamber 11, so as to supply gas to a wafer 13 placed on a lower surface of the chamber 11. Valves 17a and 17b are provided at the nozzles 16a and 16b, respectively, so as to control the quantity of the supplied gas.

The CCD 20 radiates light into the chamber 11 through the light emission tip 15 and receives the light reflected by the wafer 13.

From among components of the light received by the CCD 20, the light component extraction section 30 extracts the component of the light having the strongest intensity.

When the component of light having been extracted by the light component extraction section 30 abruptly changes (increases or decreases), the determination section 40 judges this point of time to be the etching completion time point and outputs an etching completion control signal corresponding to the etching completion time point.

The gas supply section 50 supplies gas into the chamber 11 through the nozzles 16a and 16b. The gas supply section 50 controls operation of the valves 17a and 17b, so as to control the quantity of the supplied gas, in response to the etching completion control signal output from the determination section 40.

In other words, the conventional plasma etching apparatus controls the operation of etching the wafer 13 according to its judgment for the etching completion time point.

However, when it is confirmed that the wafer has not been uniformly etched even after the etching process, the conventional plasma etching apparatus must perform the etching process again. In this case, the etching process is carried out by changing various etching conditions such as the quantity of the gas supplied by the gas supply section 50, time for which light is injected by the CCD 20, etc. Also, in order to maintain a uniform density of the plasma in the chamber 11, various etching conditions must be adjusted. When the etching conditions are improper, there are often produced wrongly-etched wafers which must be discarded. In fact, several tens or hundreds of wafers have often been wasted due to improper etching conditions in the conventional plasma etching method.

Further, as shown in Figure 4, the light emission tip 15 exposed to the interior space of the chamber 11 has a lower end bulging downward. Therefore, since the light emitted from the light emission tip 15 is dispersed in all directions in the chamber 11, the quantity of light reaching the wafer 13 is not large. Likewise, since the light reflected by the wafer 13 is also dispersed in all directions in the chamber 11, the quantity of reflected light received by the light emission tip 15 is not large.

Further, as shown by the enlarged view in Figure 4, a lower edge portion A of the dome 12, which is in contact with the light emission tip 15, may be separated, thereby producing inferior wafers.

The dome 12 is made from alumina Al2O3 having a dielectric constant ε1 ranging between 9.3 and 9.8, and the electric field generated by an inductive power supply section (not shown) is introduced into the chamber through the dome having the dielectric constant ε1.

In this case, the introduced electric field discharges the gas contained in chamber, thereby changing the gas into a plasma state. Further, neutral radical particles produced in this process make chemical reaction with charged ions on an etched object, thereby etching portions of the surface of the wafer which have not been covered by a mask.

Hereinafter, a description and comparison will be given of the conventional ICP and CCP etching methods.

### (1) Etching selectivity

Etching selectivity signifies a relative proportion between speeds at which thin films of different kinds are etched when the thin films are etched under the same plasma condition. Therefore, the larger the etching selectivity is, the more preferable it is.

A photoresist (PR) etching selectivity has a proportion smaller than 3:1 when a photoresist film applied on a predetermined layer is etched in a plasma etching apparatus according to the conventional ICP etching method. In contrast, the PR etching selectivity has a proportion between 3:1 and 6:1 when a photoresist film applied on a predetermined layer is etched in a plasma etching apparatus according to the conventional CCP etching method. Therefore, the CCP etching method exhibits better performance in regard to the etching selectivity in etching a photoresist film.

### (2) Etch rate

Etch rate signifies an etched quantity of an object per unit period of time and usually employs Å/min as its unit. Therefore, the larger the etch rate is, the better it is.

In the case of a plasma etching apparatus employing the conventional ICP etching method, when the pressure in a chamber has a value of 40 to 80 mT, the etch rate has a value of 4000 to 5000 Å/min and is inversely proportional to the pressure. In contrast, in the case of a plasma etching apparatus employing the conventional CCP etching method, when the pressure in a chamber has a value of 40 to 80 mT and a bias electric power is increased up to 1600 W, the etch rate has a value of 8000 to 9000 Å/min and is proportional to the pressure.

In other words, the CCP etching method exhibits a larger etch rate than the ICP etching method in the case where the pressure in the chamber has a value between 40 and 80 mT. Also, the CCP etching method shows an etch rate proportional to the pressure. Therefore, the CCP etching method exhibits better characteristics than the ICP etching method, in relation to the etch rate.

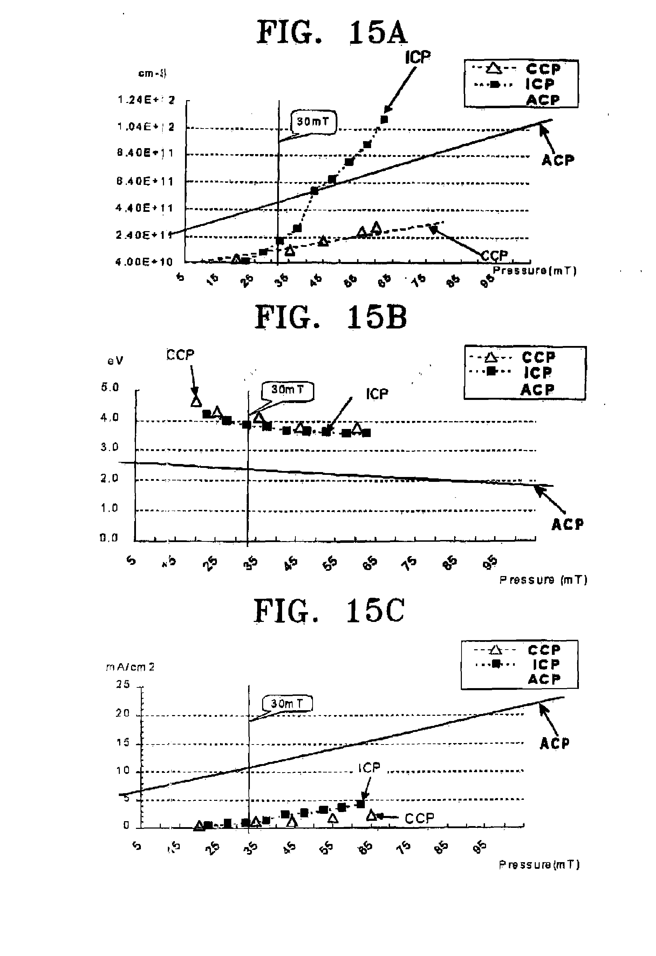

### (3) Plasma density (see Figure 15A)

Since a wafer is etched by plasma, the higher the plasma density is, the better it is. Also, the higher the pressure in the chamber is, the higher the plasma density is. Therefore, a low pressure in the chamber is not preferable in views of reproducibility, repeatability, and stability of process.

In a plasma etching apparatus employing the conventional ICP etching method, in the case where the pressure in a chamber has a value of 30 mT, a plasma density is about 2.40 × 10¹¹ cm⁻³ when an electric power of 1000 W is supplied, and is about 10¹²cm⁻³ when an electric power of 2800 W is supplied. That is, the plasma density abruptly increases according to an increase of pressure. In contrast, in a plasma etching apparatus employing the conventional CCP etching method, in the case where the pressure in a chamber has a value of 30 mT, a plasma density is about 3.20 × 10¹⁰ cm⁻³ and increases at a considerably slow rate according to the increase of pressure. Therefore, the ICP etching method has a better characteristic than the CCP etching method, in relation to the plasma density.

### (4) Electron particle temperature (see Figure 15B)

The electron particle temperature signifies temperature of electron particles in the plasma. In general, the absolute temperature or Kelvin temperature K is employed as a unit of temperature. However, since the temperature of electron particles has a very high value in the absolute temperature unit, eV is employed as the unit of the temperature of electron particles (12,400 K corresponds to about 1 eV).

When the temperature of the electron particles is low, the temperature of the plasma in the chamber is also low, so that damage to the wafer by the plasma can be reduced. In contrast, when the temperature of the electron particles grows higher, the electron particles having a high energy may permeate into the wafer, thereby causing junction damage. Therefore, the lower the temperature of the electron particles is, the better it is.

When the pressure in the chamber is 30 mT, the temperature of the electron particles is measured as about 4.0 eV in either the plasma etching apparatus employing the conventional ICP etching method or the plasma etching apparatus employing the conventional CCP etching method. Therefore, a low electron temperature is not found in either the plasma etching apparatus employing the conventional CCP etching method or the plasma etching apparatus employing the conventional ICP etching method.

### (5) Ion current density (see Figure 15C)

The current density of ions in the plasma is measured in units of mA/cm². The larger the ion current density is, the larger the etching speed or the etch rate is. Therefore, the larger the ion current density is, the better.

In both the plasma etching apparatus employing the conventional ICP etching method and the plasma etching apparatus employing the conventional CCP etching method, when the pressure in the chamber is 30 mT, the ion current density is about 1 mA/cm², although it is measured as slightly higher in the ICP etching method than in the CCP etching method. However, it has been noticed that the ion current density does not increase much even when the pressure in the chamber increases in both of the above two methods.

As described above, each of the ICP etching method and the CCP etching method has its own advantages and disadvantages. Therefore, development of a new plasma etching method having only the advantages of the two methods and a new apparatus employing the new method is desirable.

Preferred embodiments of the present invention aim to provide one or more of the following:
a plasma etching method and apparatus for manufacturing a semiconductor device, in which a dome sealing a plasma chamber has a curved inner surface facing and bulging toward an interior space of the chamber, so that the density of plasma in the chamber can be maintained to be uniform;
a plasma etching method and apparatus for manufacturing a semiconductor device, in which a dome sealing a plasma chamber has a curved inner surface facing an interior space of the chamber, a central portion of which bulges further toward the interior space than an edge portion of the curved inner surface, the dome including at least two layers having dielectric constants different from each other, so that the density of plasma in a chamber can be maintained to be uniform;
a plasma etching method and apparatus for manufacturing a semiconductor device, which employ a four-arm to eight-arm spiral coil placed on the dome, thereby preventing an arc discharge from being generated at a grounded portion of the coil as well as maintaining the density of plasma in a chamber uniform;
a plasma etching method and apparatus for manufacturing a semiconductor device, which employ a light emission tip having a concave lower end, which means that the surface of the lower end is curved upward, thereby increasing the reflectance of the light transmitted into a plasma chamber and preventing a contact portion between the light emission tip and a dome from being separated, deposited on the surface of the wafer, and then forming impurities on the wafer;
a plasma etching method and apparatus for manufacturing a semiconductor device, in which intensities of specific light components according to wavelengths are compared and quantity of gas introduced into a plasma chamber is adjusted according to a result of the comparison by utilizing a light emission tip, so that the density of plasma in a chamber can be maintained to be uniform;
a plasma etching method and apparatus for manufacturing a semiconductor device, which employ light emission tips disposed through a central portion and at least one edge portion of a dome, so that proportional values for intensities of specific light components extracted at the central and edge portions of the dome, and quantity of gas introduced through the edge portion is adjusted on the basis of a difference value between the two proportional values, thereby maintaining the density of plasma in a chamber uniform;
a plasma etching method and apparatus for manufacturing a semiconductor device, in which a proportion between a source electric power and a bias electric power has a value of 1:(6 to 20), the plasma etching apparatus including one of four-arm to eight-arm spiral coils, thereby improving a photoresist (PR) etching selectivity, which is one of the characteristics of the plasma etching apparatus;
a plasma etching method and apparatus for manufacturing a semiconductor device, in which a proportion between a source electric power and a bias electric power has a value of 1:(6 to 20), the plasma etching apparatus including one of four-arm to eight-arm spiral coils, thereby improving an etch rate, which is one of the characteristics of the plasma etching apparatus;
a plasma etching method and apparatus for manufacturing a semiconductor device, in which a proportion between a source electric power and a bias electric power has a value of 1:(6 to 20), the plasma etching apparatus including one of four-arm to eight-arm spiral coils, thereby improving a plasma density, which is one of the characteristics of the plasma etching apparatus;
a plasma etching method and apparatus for manufacturing a semiconductor device, in which a proportion between a source electric power and a bias electric power has a value of 1:(6 to 20), the plasma etching apparatus including one of four-arm to eight-arm spiral coils, thereby improving a temperature of electron particles, which is one of the characteristics of the plasma etching apparatus;
a plasma etching method and apparatus for manufacturing a semiconductor device, in which a proportion between a source electric power and a bias electric power has a value of 1:(6 to 20), the plasma etching apparatus including one of four-arm to eight-arm spiral coils, thereby improving a ion current density, which is one of the characteristics of the plasma etching apparatus;

According to one aspect of the present invention, there is provided a plasma etching apparatus for manufacturing a semiconductor device, the apparatus comprising:
a chamber in which a wafer to be etched is loaded;
a first dome sealing an upper end of the chamber;
a coil wound on the dome and generating an electric field into the chamber;
at least one light emission tip disposed through a predetermined portion of the dome, so as to emit light toward the wafer and receive light reflected by the wafer;
a plurality of nozzles, each of which is disposed around a light emission tip and through a predetermined portion of the dome, so as to supply gases into the chamber; and
a plurality of valves, which are provided each at each of the nozzles, so as to adjust quantity of the gases supplied into the chamber:
   wherein the first dome has a flatted outer surface and curved inner surface facing an interior space of the chamber, and a central portion of the curved inner surface bulges further than an edge portion thereof toward the interior space of the chamber.

In another aspect, the invention provides a plasma etching apparatus for manufacturing a semiconductor device, the apparatus comprising:
a chamber in which a wafer to be etched is loaded;
a first dome sealing an upper end of the chamber;
a coil wound on the dome and generating an electric field into the chamber;
at least one light emission tip disposed through a predetermined portion of the dome, so as to emit light toward the wafer and receive light reflected by the wafer;
nozzles, each of which is disposed around light emission tip and through a predetermined portion of the dome, so as to supply gases into the chamber;
valves, which are provided each at each of the nozzles, so as to adjust quantity of the gases supplied into the chamber; and
at least one state control section including a light component extraction section, a proportional value estimation section, a comparison section, and a control section, the light component extraction section extracting predetermined light components from among the light received through the light emission tip and obtaining intensities of the extracted light components, the proportional value estimation section estimating a proportional value between the intensities of the extracted light components, the comparison section comparing the estimated proportional value with a reference value, the control section controlling operations of the valves according to a compared result from the comparison section.

Preferably, the first dome has a flatted outer surface and a curved inner surface facing an interior space of the chamber, and a central portion of the curved inner surface bulges further than an edge portion thereof.

Preferably, the apparatus further comprises a second dome attached to the outer surface of the first dome and having a dielectric constant different from that of the first dome.

Preferably, the first dome has a dielectric constant smaller than that of the second dome.

Preferably, the coil has one of four-arm to eight-arm spiral shapes.

Preferably, the light emission tip has a concave lower end which prevents the light emission tip from protruding beyond a lower surface of the dome.

Preferably, the light emission tip is disposed through a central portion of the dome.

Preferably, the light emission tip is disposed not only through a central portion but also through at least one edge portion of the dome.

Preferably, a plasma etching apparatus as above further comprises a bias electric power supply section which applies bias electric power to a bottom of the chamber.

In another aspect, the invention provides a plasma etching method for manufacturing a semiconductor device, the method comprising:
extracting predetermined light components reflected by a wafer placed in a chamber, and obtaining intensities of the extracted light components;
estimating a proportional value between the intensities of the extracted light components;
comparing the estimated proportional value with a reference value; and
controlling quantity of gases supplied into the chamber according a compared result.

Preferably, the predetermined light component comprises CFx and SiOx components, the quantity of CF⁴ gas is increased when the estimated proportional value is larger than the reference value, and the quantity of O² gas is increased when the estimated proportional value is smaller than the reference value.

In another aspect, the invention provides a plasma etching method for manufacturing a semiconductor device by means of a plasma etching apparatus, the plasma etching apparatus including a chamber in which a wafer is loaded and etched, a dome sealing an upper end of the chamber, one selected from a four-arm to eight-arm spiral coils placed on the dome and supplying electricity into the chamber, and a bias electric power supply section applying bias electric power to a bottom of the chamber, the method comprising:
supplying electric power, wherein a bias electric power having a magnitude of n is applied to the spiral coil while a bias electric power having a magnitude of m is applied to a bottom surface of the chamber; and
generating a plasma, wherein the applied bias electric powers generate an electric field, thereby generating the plasma.

Preferably, m/n has a value between 6 and 20.

Preferably, n has a value between 90 and 100 Watts, and m has a value between 900 and 1000 Watts.

A method as above is preferably performed at a photoresist (PR) etching selectivity of x:1 where x is at least 6.

A method as above is preferably performed at an etch rate ranging between 8000 and 9000 Å/min when the pressure in a chamber has a value between 40 and 80 mT and a bias electric power has a value of 1600 W.

A method as above is preferably performed at a plasma density ranging between 4.40 × 1011 cm-3 and 1.04 × 1012 cm-3 when the pressure in the chamber has a value between 40 and 80 mT and the source electric power is 1000 W.

A method as above is preferably performed at an electron particle temperature having a value not larger than 3.0 eV.

A method as above is preferably performed at an ion current density having a value between 10 and 20 mA/cm2 when the pressure in the chamber has a value between 40 and 80 mT and the source electric power is 1000 W.

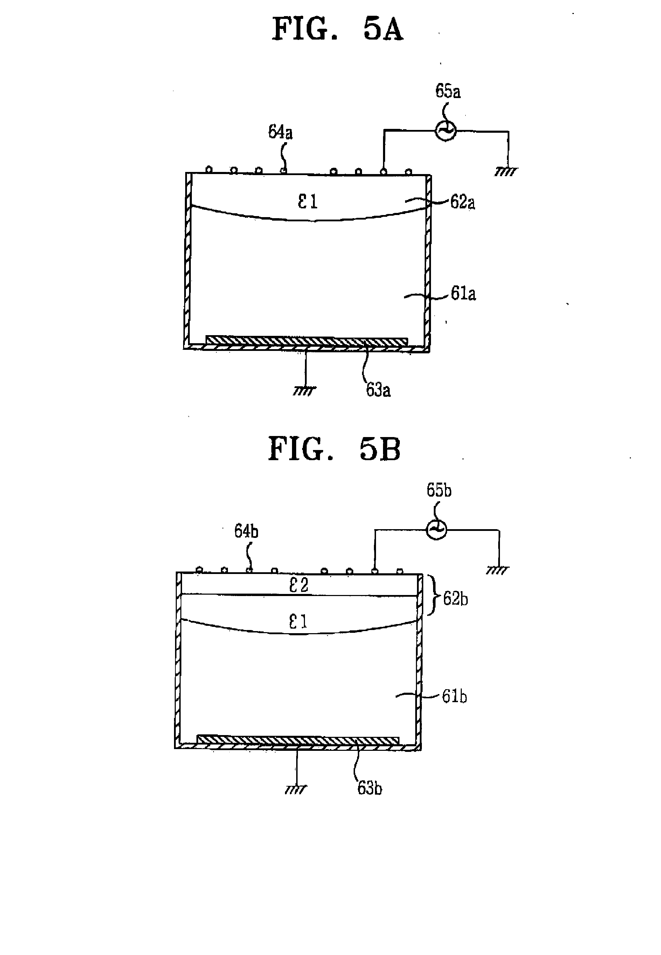

For a better understanding of the invention, and to show how embodiments of the same may be carried into effect, reference will now be made, by way of example, to Figures 5 to 15 of the accompanying diagrammatic drawings, in which:
Figure 5A is a sectional view of a chamber of one example of a plasma etching apparatus according to an embodiment of the present invention;
Figure 5B is a sectional view of a chamber of one example of a plasma etching apparatus according to another embodiment of the present invention;

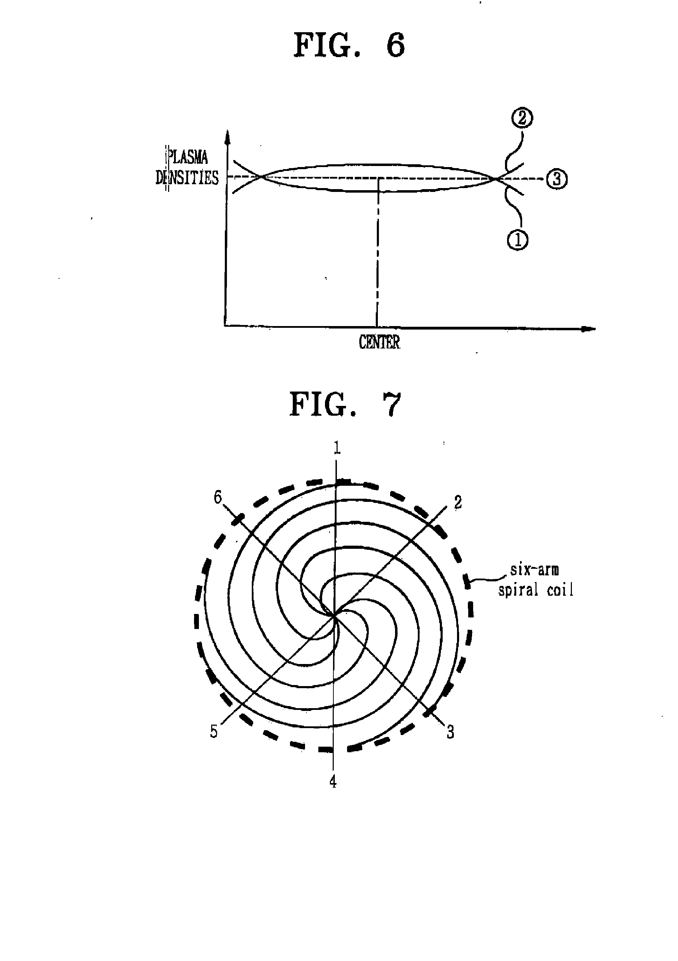

Figure 6 is a graph showing plasma densities in the chambers shown in Figures 5A and 5B;
Figure 7 is a plan view of a coil employed in a plasma etching apparatus according to one example of the present invention;

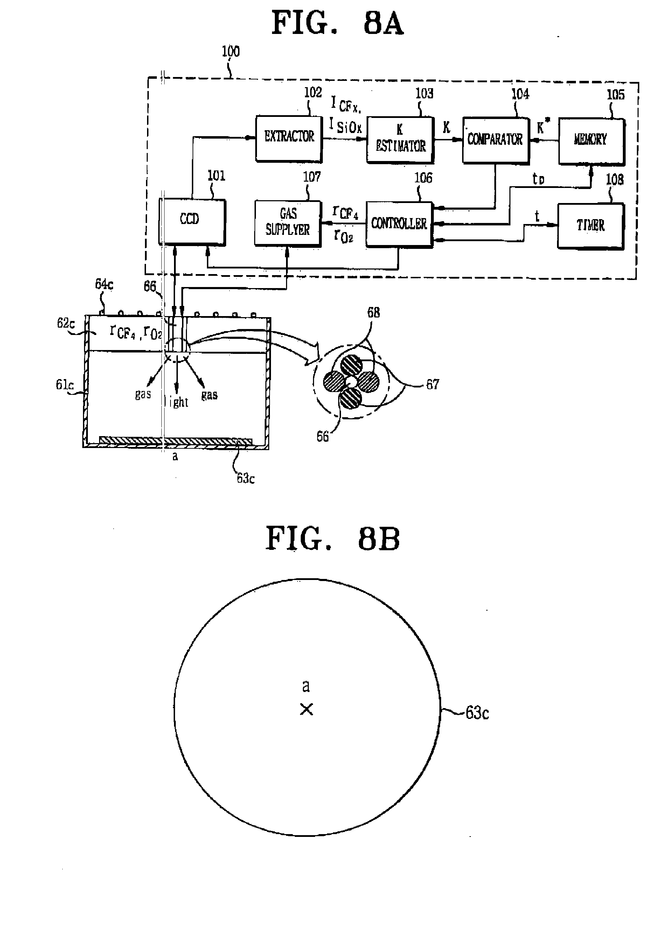

Figure 8A is a view including a block diagram, which shows a construction of one example of a plasma etching apparatus according to an embodiment of the present invention;
Figure 8B is a plan view of a wafer on which projected locations of a light emission tip are marked;

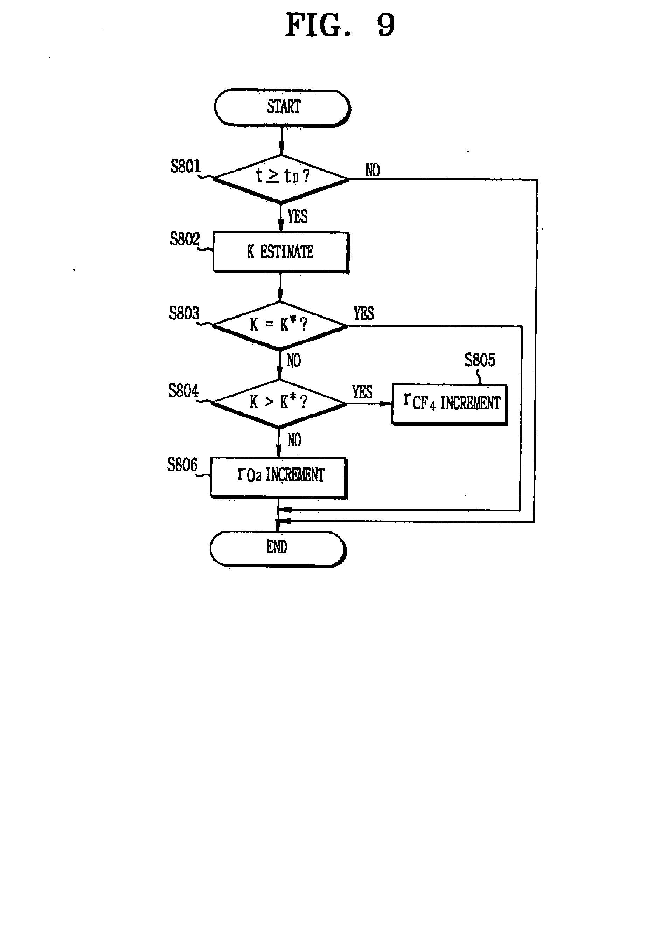

Figure 9 is a flowchart of one example of a plasma etching method according to an embodiment of the present invention, which utilizes a plasma etching apparatus shown in Figure 8A;
Figure 10A is a view including a block diagram, which shows a construction of one example of a plasma etching apparatus according to another embodiment of the present invention;

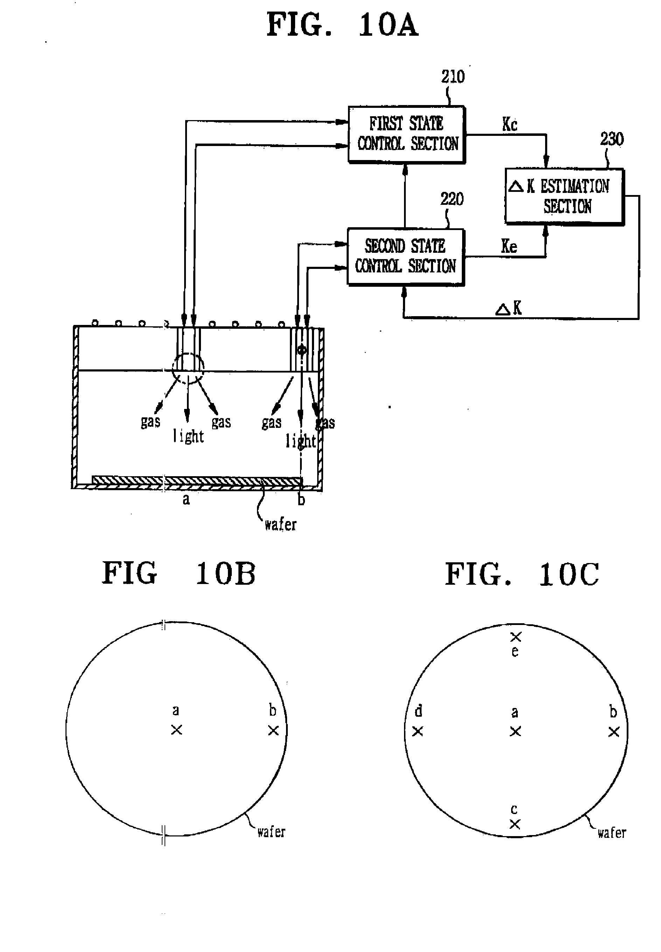

Figures 10B and 10C are plan views of wafers on which projected locations of a light emission tip are marked;

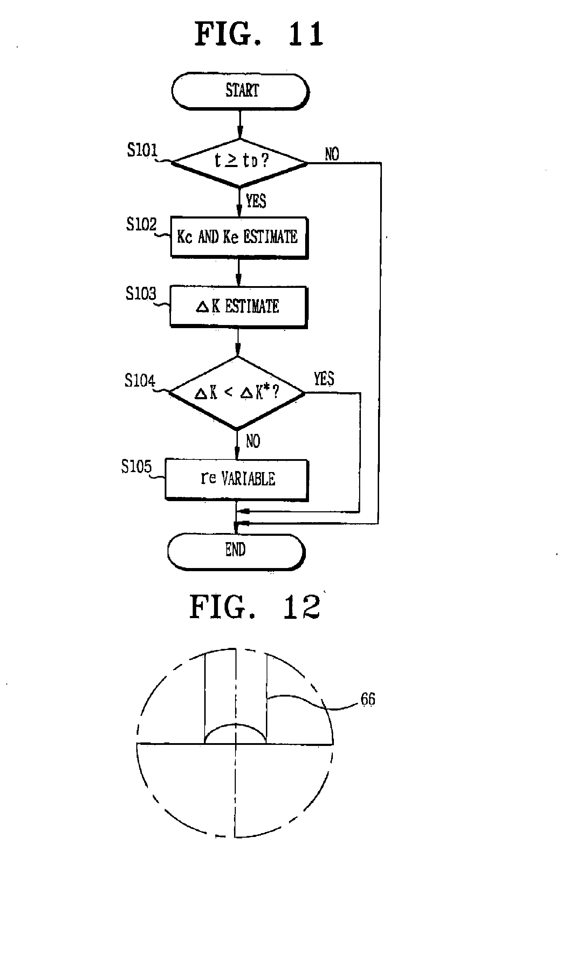

Figure 11 is a flowchart of one example of a plasma etching method utilizing the plasma etching apparatus shown in Figure 10A;
Figure 12 is an enlarged side view of a concave lower end of a light emission tip employed in one example of a plasma etching apparatus according to an embodiment of the present invention;

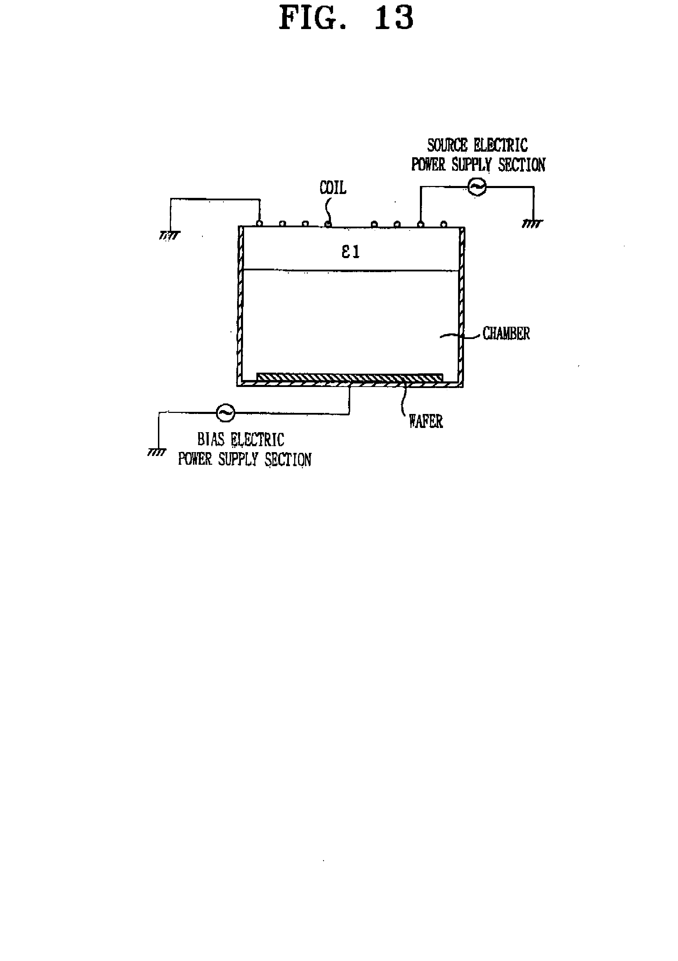

Figure 13 is a sectional view of a chamber employed in one example of a plasma etching apparatus according to another embodiment of the present invention;

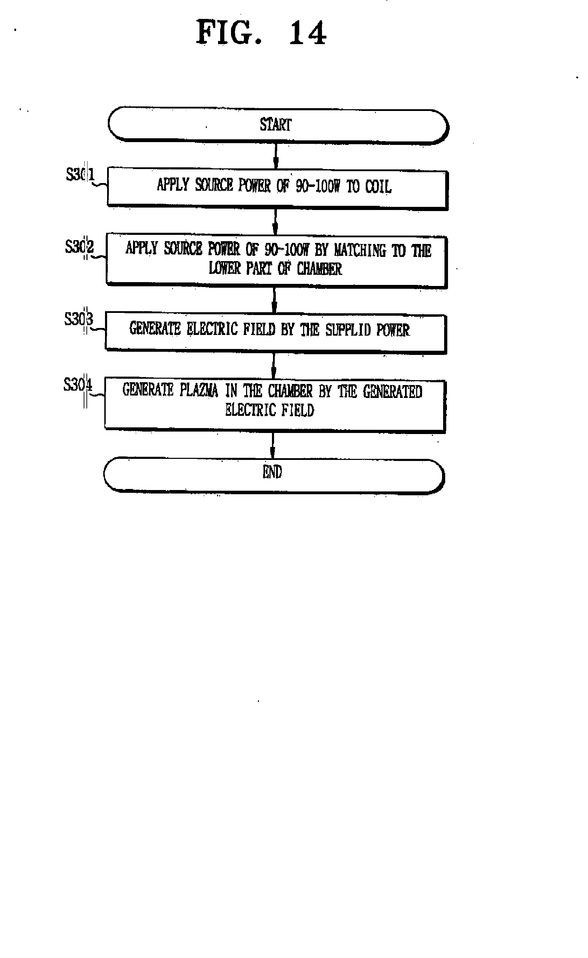

Figure 14 is a flowchart of an Adaptively Coupled Plasma generation method (ACP) employed in one example of a plasma etching method according to an embodiment of the present invention; and
Figures 15A through 15c are graphs showing comparison between the characteristics of ACP according to examples of the present invention and those of conventional ICP and CCP.

In the figures, like references denote like or corresponding parts.

Reference will be made firstly to Figures 5 to 7.

First, in a chamber 61a shown in Figure 5A, the centre portion a lower surface of a dome 62a exposed to an inner surface of the chamber 61a bulges downward in a view from a front side of the chamber 61a.

That is, on the basis of a wafer 63a placed on the bottom of the chamber 61a, the distance between central portions of the dome 62a and the wafer 63a is smaller than that between edge portions of the dome 62a and the wafer 63a.

Further, the dome 62a is formed of a single layer made from alumina having a dielectric constant ε1 of 9.3 to 9.8. According to another embodiment of the present invention, the dome may be formed of not a single layer but at least two layers having different dielectric constants. Especially, in the case of a dome 62b having two layers as shown in Figure 5B, it is preferred that the dielectric constant ε2 of the upper layer exposed to the exterior of the chamber 61b is larger than a dielectric constant ε1 of the lower layer exposed to the interior of the chamber 61b.

As shown in Figure 6, in consideration of only the characteristic of the conventional coil placed on the dome 62a or 62b, the density of plasma generated by an electric field induced by the coil and introduced into the chamber 61a or 61b has a higher value at the central portion of the wafer than that at the edge portion of the wafer.

Further, in consideration of only the characteristic of the dome according to an embodiment of the present invention (shown in Figures 5A or 5B), the electric field passing through the dome 62a or 62b has a weaker intensity at the central portion of the dome 62a or 62b than at the edge portions of the dome 62a or 62b, so that the density of plasma has a higher value at the central portion of the wafer 63a or 63b than at the edge portion of the wafer 63a or 63b.

Therefore, in consideration of the combination of the conventional coil and the domes according to embodiments of the present invention, the characteristics of the plasma densities and by the conventional coil and the domes according to embodiments of the present invention are combined together, so as to yield a characteristic of a combined plasma density , in which the plasma density is uniform from the central portion to the edge portion of the wafer.

In addition, the plasma etching apparatus according to an embodiment of the present invention has a four-arm to eight-arm spiral coil, so that, when a high electric power is applied from the inductive power supply section, the high electric power is divided into electric powers having a magnitude of 1/4 to 1/8 of the high electric power, and the divided electric powers are applied to the coils. As a result, the electric field can be stably generated even at the grounded portions or edge portions of the coil.

Further, in consideration of the fact that the electric power applied to the coil by the inductive power supply section has a value ranging between 800 and 1500 W, a six-arm spiral coil as shown in Figure 7 is most preferable, so as to enable the electric power to be divided into as many lower electric powers as possible while preventing the gaps between the coil arms from being too compact.

Figure 8A is a view including a block diagram, which shows a construction of a plasma etching apparatus according to an embodiment of the present invention.

As shown, the plasma etching apparatus includes a chamber 61c and a state control section 100. The chamber 61c includes a dome 62c, a wafer 63c, a coil 64c, and a light emission tip 66. The state control section 100 includes a CCD 101, a light component extractor 102, a K estimator 103, a comparator 104, a memory 105, a controller 106, a gas supply section 107, and a timer 108. In this case, the plasma etching apparatus may have a combination of the dome 62a or 62b shown in Figure 5A or 5B and the six-arm spiral coil shown in Figure 7.

Further, a light emission tip 66 having an elongated tubular shape and two pairs of nozzles 67 and 68 are inserted through a central portion of a dome 62c, and each of the nozzles is provided with a valve controlling a quantity of gas passing through the nozzle. Preferably, the light emission tip 66 and the two pairs of nozzles 67 and 68 may be disposed so that they are faced to the centre of the wafer 63c.

Especially, as shown in Figure 8A, oxygen gas O² is supplied through a pair of nozzles 67 into the chamber 61c, and CF⁴ gas is supplied through a pair of nozzles 68 into the chamber 61c.

In this case, a lower end of the light emission tip 66, which is exposed to the inner space of the chamber 61c, may have a concave surface, that is, a surface curved upward, as shown in Figure 12. Differently from light emission tips employed in conventional plasma etching apparatuses, the light emission tip 66 having the construction described above can prevent the light emitted from the light emission tip 66 from being dispersed and increase a probability that the light can be focused on the surface of the wafer 63c. Also, the light emission tip 66 having the construction described above can solve another problem of the conventional light emission tip, that is, the light emission tip 66 can prevent a contact portion between the light emission tip 66 and the dome 62c from being separated, deposited on the surface of the wafer 63c, and then forming impurities on the wafer 63c.

The CCD 101 emits light through the light emission tip 66 toward the wafer 63c in the chamber 61c and receives light reflected by the wafer 63c.

The light component extractor 102 extracts fluorocarbon CF^{x} series and silicon oxide SiO^{x} series light components from among the light input to the CCD 101, and obtains intensities I^{CFx} and I^{siOx} of the extracted light components.

The K estimator 103 estimates a proportional value K between the obtained intensities I^{CFx} and I^{siOx} of the CF^{x} and SiO^{x} light components.

The comparator 104 compares the estimated proportional value K with a reference value K* read from the memory 105.

According to a result of the comparison, the controller 106 controls valves provided at the two pairs of nozzles, so as to adjust gas flow rates r^{CF4} and r^{O2} of the carbon fluoride CF⁴ and oxygen O² gases. Also, the controller 106 compares a current time, when a wafer is carried into the chamber 61c with a reference time t^{D} read from the memory 105, and controls the CCD 101 and the gas supply section 107 so as to initiate a state control operation according to a result of the comparison. The reference time t^{D} is a maximum time capable of maintaining the characteristic in the chamber 61c during operation, also signifies a period from the carried-in time of a wafer to the carried-in time of next wafer.

The gas supply section 107 supplies the CF⁴ and O² gases according to the gas flow rates controlled by the controller 106.

The timer 108 continuously renews and stores the current time.

Hereinafter, a plasma etching method according to one example of the present invention will be described with reference to Figure 9.

Figure 9 is a flowchart of one example of a plasma etching method according to the present invention, which utilizes a plasma etching apparatus shown in Figure 8A.

First, the controller 106 periodically reads a current time t from the timer 108 and compares the difference time between the current time and the time when the last wafer is carried into the chamber 61c with the reference time t^{D} read from the memory 105.

Usually, the reference time t^{D} is set as about four hours. The internal state of the chamber must be controlled during the reference time. Therefore, the plasma etching apparatus is set in such a manner that it advances to another etching operation when the reference time has passed after completion of a previous etching operation.

Therefore, according to a result of the comparison, when the reference time tD is smaller than the difference time t (step S801), the controller 106 does not continue but stops the state control operation. In contrast, when the difference time is equal to or larger than the reference time (step S801), the controller 106 controls the CCD 101 and the gas supply section 107 to start their operation.

As a result, the CCD 101 supplies light into the chamber 61c through the light emission tip 66 and receives light reflected by the wafer 63c through the light emission tip 66.

Next, the light component extractor 102 extracts CF^{x} and SiO^{x} light components from among the light input to the CCD 101, thereby obtaining intensities I^{CFx} and I^{siOx} of the extracted light components, and the K estimator 103 estimates a proportional value K between the obtained intensities I^{CFx} and I^{siOx} of the CF^{x} and SiO^{x} light components (step S802). The estimated proportional value K is I^{siOx}/I^{CFx}.

Thereafter, the comparator 104 compares the estimated proportional value K with the reference value K* read from the memory 105 (step S803). According to a result of the comparison, when the two values are the same ("yes" in step S803), the state control operation is stopped, and the controller 106 initializes the current time t stored in the timer 108 to zero and controls the timer 108 to continuously renew and store the current time until a next state control operation is started.

In contrast, as a result of the comparison, when the proportional value K is not equal to the reference value K* (step S803) and is larger than the reference value K* (step S804), the controller 106 controls the gas supply section 107 to increase the gas flow rate r^{CF4} of the CF⁴ gas (step S805), which corresponds to a denominator of the proportional value, so as to equalize the proportional value to the reference value, so that more CF⁴ gas can be supplied into the chamber through the CF⁴ nozzle.

Further, when the proportional value K is smaller than the reference value K* (step S804), the controller 106 controls the gas supply section 107 to increase the gas flow rate r^{O2} of the O² gas (step S806), which corresponds to a numerator of the proportional value, so as to equalize the proportional value K to the reference value K*, so that more O² gas can be supplied into the chamber through the O² nozzle.

When the state control operation as described above has been completed, the controller 106 initializes the timer 108 in the same manner as described above, so as to enable the timer 108 to continuously renew and store the current time until a next state control operation is started.

Figure 10A is a view including a block diagram, which shows a construction of a plasma etching apparatus according to another embodiment of the present invention. Further, Figures 10B and 10C are plan views of wafers on which projected locations of the light emission tip are marked, and Figure 11 is a flowchart of a plasma etching method utilizing the plasma etching apparatus shown in Figure 10A.

It is presumed that the plasma etching apparatus shown in Figure 10A includes the dome shown in Figure 5A or 5B, the coil shown in Figure 7, and the light emission tip shown in Figure 12.

The previous embodiment proposes an apparatus and a method utilizing the apparatus, in which one light emission tip is inserted through the central portion of the dome, so as to cause the plasma density to be uniform at the central portion of the dome. However, in the present embodiment, the light emission tip is inserted not only through the central portion but also through at least one edge portion of the dome, so that the plasma density can have a uniform value not only at the central portion but also at the edge portion of the dome. Moreover, the apparatus according to the present embodiment includes an additional component which compares the plasma density at the central portion of the dome with that at the edge portion of the dome, so as to equalize the two densities.

In the present embodiment, not only the light emission tips are inserted through the central portion and at least one edge portion of the dome, but also two pairs of nozzles are disposed around each of the light emission tips and each of the nozzles is provided with a valve for controlling the gas flow rate through the nozzle, as in the previous embodiment.

In this case, projected locations a and b of the light emission tips each with two pairs of nozzles may correspond to central and edge portions of an upper surface of the wafer as shown in Figure 10B.

Of course, in the case of an apparatus according to another embodiment, in which light emission tips each having two pairs of nozzles around it are disposed at a central portion and four edge portions of the dome, they may be projected toward locations a, b, c, d, and e of the surface of the wafer as shown in Figure 10C.

The plasma etching apparatus according to the present embodiment includes first and second state control sections 210 and 220 corresponding to the state control section 100 in the previous embodiment, and a ΔK estimation section 230 which estimates a difference value ΔK between proportional values Kc and Ke estimated by the first and second state control sections 210 and 220, respectively.

A controller (not shown) in the second state control section 220 determines whether the difference value ΔK received from the ΔK estimation section 230 is within a range of a reference difference value ΔK* read from the memory 105 or not. Then, according to the result of the determination, the controller section controls a gas supply section (not shown) to adjust gas flow rates r^{CF4} and r^{O2} through the nozzle inserted through the edge portion of the dome by means of its valve, thereby controlling the quantity of the CF⁴ OR O² gas supplied into the chamber by the gas supply section (not shown).

Hereinafter, the operation of the plasma etching apparatus according to the present embodiment will be described with reference to Figure 11. Further, although elements of the first and second state control sections 210 and 220, which have the same names as those the elements of the state control section 100 shown in Figure 8A.

First, the controller 106 periodically reads current time t from the timer 108 and compares the difference time with the reference time tD read from the memory 105 (step S101).

As a result of the comparison, when the difference time t is smaller than the reference time period (step S101), the controller 106 does not perform but stops the state control operation. On the contrary, when the difference t is equal to or larger than the reference time period (step S101), the controller 106 controls the CCD 101 and the gas supply section 107 to start their operation.

As a result, the CCD 101 supplies light into the chamber through the light emission tip and receives light reflected by the wafer through the light emission tip.

Next, the light component extractor 102 extracts CF^{x} and SiO^{x} light components from among the light input to the CCD 101, and obtains intensities I^{CFx} and I^{siOx} of the extracted light components, and the K estimator 103 estimates proportional values Kc and Ke between the obtained intensities I^{CFx} and I^{siOx} of the CF^{x} and SiO^{x} light components (step S102). The proportional values Kc and Ke are estimated by I^{siOx}/I^{CFx}.

When the proportional values Kc and Ke estimated in this way are input to the ΔK estimation section 230, the ΔK estimation section 230 estimates a difference value ΔK between the two input proportional values (step S103) and transmits the difference value ΔK to a controller 106 in the second state control section 220. In this case, the estimated difference value ΔK is defined as an expression, Kc - Ke.

The controller 106 determines whether or not the transmitted difference value belongs to a range of a reference difference value ΔK* read from a memory 105 (step S104).

As a result of the comparison, when the transmitted difference value belongs to the range of the reference difference value ΔK* (step S104), the state control operation is stopped and the controller 106 initializes the timer 108, thereby enabling the timer 108 to renew and store the current time until a next state control operation is performed.

In contrast, when the transmitted difference value does not belong to the range of the reference difference value ΔK* (step S104), the controller 106 adjusts the gas flow rate r^{e} (step S105) so that the transmitted difference value conforms to the reference difference value range.

In other words, when the difference value is larger than the reference difference value, which means when Kc is larger than Ke, the controller 106 controls the gas supply section 107 to increase the gas flow rate r^{CF4} of the CF⁴ gas, which corresponds to a denominator of the value Ke, so as to enable the difference value to conform to the reference difference value range, so that more CF⁴ gas can be supplied into the chamber through the CF⁴ nozzle.

Further, when the difference value is smaller than the reference difference value, which means when Kc is smaller than Ke, the controller 106 controls the gas supply section 107 to increase the gas flow rate r^{O2} of the O² gas, which corresponds to a numerator of the value Ke, so as to enable the difference value to conform to the reference difference value range, so that more O² gas can be supplied into the chamber through the O² nozzle.

When the state control operation as described above has been completed, the controller 106 initializes the timer 108 in the same manner as described above, so as to enable the timer 108 or 108 to continuously renew and store the current time until a next state control operation is started.

In consideration of the conventional plasma generating methods which are called CCP, ICP, and so forth, a method of generating plasma according to an example of the present invention will be hereinafter called ACP (Adaptively Coupled Plasma generation method).

Figure 13 is a sectional view of a chamber employed in a plasma etching apparatus according to another embodiment of the present invention.

The plasma etching system according to the present embodiment has a six-arm spiral coil (see Figure 7), and includes a source electric power supply section and a bias electric power supply section.

Figure 14 is a flowchart of the ACP employed in a plasma etching method according to an embodiment of the present invention, and Figures 15A to 15c are graphs showing comparison between the characteristics of the ACP according to an embodiment of the present invention and those of the conventional ICP and CCP.

Hereinafter, the ACP employed in a plasma etching method according to an embodiment of the present invention will be described with reference to Figures 14 and 15A to 15C.

First, the source electric power supply section applies an electric power of 90 to 100 W to the coil placed on the dome (step S301), and the bias electric power supply section is connected with and applies a bias electric power of 900 to 1000 W to the bottom of the chamber (step S302).

In this case, when the size of the wafer is 200 mm, the source electric power may have a value of 50 to 1000 W and the bias electric power may have a value of 100 to 2500 W.

For reference, the source electric power determines the density of the ions in the plasma generated in the chamber, and the bias electric power determines the energy of the ions. In the present embodiment, the proportion between the source electric power and the bias electric power has a value of 1:(6 to 20), so as to optimize various characteristics of the plasma etching apparatus, which include the photoresist (PR) etching selectivity, etch rate, plasma density, temperature of electron particles, and ion current density. The ratio of the source power spply to the bias electric power supply is to 1:16∼20. A more detailed description about the above-mentioned characteristics will be given below.

Thereafter, an electric field is generated by the source and bias electric powers applied as described above (step S303), so as to generate plasma in the chamber (step S304).

Hereinafter, the five characteristics of the plasma etching apparatus, in which the plasma is generated in the way as described above, will be described in sequence.

### (1) PR etching selectivity

In the present embodiment employing the ACP method, the PR etching selectivity has a value of x:1, in which x is at least 6.

The larger the PR etching selectivity is, the better. The PR etching selectivity has a proportion smaller than 3:1 in a plasma etching apparatus employing ICP method, while having a proportion between 3:1 and 6:1 in a plasma etching apparatus employing CCP method. That is, in the PR etching selectivity, the CCP method shows better performance than the ICP method. However, the ACP method according to an embodiment of the present invention shows performance better than even the CCP method.

### (2) Etch rate

In the present embodiment employing the ACP method, the etch rate has a value between 8000 and 9000 Å/min and is proportional to the pressure in the chamber when the pressure has a value between 40 and 80 mT and the bias electric power has a value of 1600 W.

The larger the etch rate is, the better. In the case of a plasma etching apparatus employing the conventional ICP etching method, when the pressure in a chamber has a value between 40 and 80 mT, the etch rate has a value of 4000 to 5000 Å/min and is inversely proportional to the pressure. In contrast, in the case of a plasma etching apparatus employing the conventional CCP etching method, when the pressure in a chamber has a value between 40 and 80 mT and a bias electric power is increased up to 1600 W, the etch rate has a value between 8000 and 9000 Å/min and is proportional to the pressure. Therefore, the CCP etching method exhibits better characteristics than the ICP etching method, in regard to the etch rate.

Further, the ACP method according to an embodiment of the present invention has a good characteristic similar to that of the CCP etching method.

### (3) Plasma density (see Figure 15A)

In the present embodiment employing the ACP method, the plasma density has a value between 4.40 × 10¹¹ cm⁻³ and 1.04 × 10¹² cm⁻³ when the pressure in the chamber has a value between 40 and 80 mT and the source electric power is 1000 W. Especially when the pressure is 30 mT, the plasma density has a value of 5.40 × 10¹¹ cm⁻³.

It is preferred that, the higher the pressure in the chamber is, the higher the plasma density is. In a plasma etching apparatus employing the conventional ICP etching method, in the case where the pressure in a chamber has a value of 30 mT, a plasma density is about 2.40 × 10¹¹ cm⁻³ when the source electric power is 1000 W, and is about 10¹² cm⁻³ when the source electric power is 2800 W. That is, the plasma density abruptly increases according to an increase of pressure. In contrast, in a plasma etching apparatus employing the conventional CCP etching method, in the case where the pressure in a chamber has a value of 30 mT, the plasma density is about 3.20 × 10¹⁰ cm⁻³ and increases at a considerably slow rate according to the increase of pressure.

Therefore, the ICP etching method has a better characteristic than the CCP etching method, in relation to the plasma density. The ACP method according to an embodiment of the present invention has a good characteristic more similar to that of the ICP method than the CCP method.

### (4) Electron particle temperature (see Figure 15B)

In the present embodiment employing the ACP method, the electron particle temperature has a value between 2.0 and 2.5 eV when the pressure in the chamber has a value between 40 and 80 mT. Especially when the pressure is 30 mT, the electron particle temperature has a value of about 2.3 eV. Further, the electron particle temperature has a value not larger than 3.0 eV regardless of the pressure in the chamber.

The lower the electron particle temperature is, the better it is. When the pressure in the chamber is 30 mT, the electron particle temperature has a value of about 4.0 eV in either the plasma etching apparatus employing the conventional ICP etching method or the plasma etching apparatus employing the conventional CCP etching method.

Therefore, both of the plasma etching apparatuses employing the conventional CCP etching method and ICP etching method have similar characteristics in regard to the electron particle temperature. However, the ACP method according to an embodiment of the present invention shows a characteristic superior to either the ICP or the CCP method.

### (5) Ion current density (see Figure 15C)

In the present embodiment employing the ACP method, the ion current density has a value between 10 and 20 mA/cm² when the pressure in the chamber has a value between 40 and 80 mT and the source electric power is 1000 W. Especially when the pressure is 30 mT, the ion current density has a value of 11 mA/cm².

The larger the ion current density is, the better. In both the plasma etching apparatus employing the conventional ICP etching method and the plasma etching apparatus employing the conventional CCP etching method, when the pressure in the chamber is 30 mT, the ion current density is about 1 mA/cm², although it is measured as slightly higher in the ICP etching method than in the CCP etching method. However, it has been noticed that the ion current density does not increase much even when the pressure in the chamber increases in both of the above two methods.

Therefore, both of the plasma etching apparatuses, which employ the conventional CCP etching method and ICP etching method, respectively, have similar characteristics in regard to the ion current density. However, the ACP method according to an embodiment of the present invention shows a characteristic superior to either the ICP or the CCP method.

As can be seen from the foregoing, the above-described embodiments of the present invention can be applied regardless of the kind of etching and sizes of wafers. Also, embodiments of the present invention may be employed especially in the case where the size of the wafer is 8 inches or 12 inches, and may be employed in various etching according to the kind of compositions of the wafers, such as oxide-etching, poly-etching, and metal-etching.

As described above, embodiments of the present invention provide a plasma etching apparatus and method, which can maintain the density of plasma uniform in a chamber of the apparatus.

Further, in an apparatus and method according to embodiments of the present invention, an arc is prevented from being generated at a coil placed on a dome of a chamber, so that an electric field can be more stably generated.

Also, an apparatus and method according to embodiments of the present invention can prevent a contact portion between a light emission tip and a dome from being separated and then forming impurities on a wafer.

Furthermore, an apparatus and method according to embodiments of the present invention can improve the PR etching selectivity, which is one of the characteristic values of a plasma etching apparatus, so that they may be utilized in a critical process requiring a high PR etching selectivity.

In addition, embodiments of the present invention can improve etch rate which is one of the characteristic values of a plasma etching apparatus, thereby improving throughput.

Moreover, embodiments of the present invention can improve plasma density which is one of the characteristic values of a plasma etching apparatus, thereby enabling a critical process, which cannot be done by the conventional ICP and CCP methods, to be effectively performed within a short time period.

In addition, embodiments of the present invention can improve plasma density which is one of the characteristic values of a plasma etching apparatus, thereby minimizing damage to wafer by the plasma and increasing yield of the apparatus.

In addition, embodiments of the present invention can improve ion current density which is one of the characteristic values of a plasma etching apparatus, thereby enabling an effective etching to be performed with a low electric power.

While exemplary embodiments of the present invention have been particularly shown and described, it will be understood by those of ordinary skill in the art that various changes in form and details may be made therein without departing from the spirit and scope of the present invention as defined by the following claims.

In this specification, the verb "comprise" has its normal dictionary meaning, to denote non-exclusive inclusion. That is, use of the word "comprise" (or any of its derivatives) to include one feature or more, does not exclude the possibility of also including further features.

The reader's attention is directed to all and any priority documents identified in connection with this application and to all and any papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A plasma etching apparatus for manufacturing a semiconductor device, the apparatus comprising:
a chamber (61a,b) in which a wafer (63a,b) to be etched is loaded;
a first dome (62a,b) sealing an upper end of the chamber (61a,b);
a coil (64a,b) wound on the dome (62a,b) and generating an electric field into the chamber (61a,b);
at least one light emission tip (66) disposed through a predetermined portion of the dome (62a,b), so as to emit light toward the wafer (63a,b) and receive light reflected by the wafer (63a,b);
a plurality of nozzles (67,68), each of which is disposed around a light emission tip (66) and through a predetermined portion of the dome (62a,b), so as to supply gases into the chamber (61a,b); and
a plurality of valves, which are provided each at each of the nozzles (67,68), so as to adjust quantity of the gases supplied into the chamber (61a,b):
wherein the first dome (62a,b) has a flatted outer surface and curved inner surface facing an interior space of the chamber (61a,b), and a central portion of the curved inner surface bulges further than an edge portion thereof toward the interior space of the chamber (61a,b).

2. A plasma etching apparatus for manufacturing a semiconductor device, the apparatus comprising:
a chamber (61c) in which a wafer (63c) to be etched is loaded;
a first dome (62c) sealing an upper end of the chamber (61c);
a coil (64c) wound on the dome (62c) and generating an electric field into the chamber (61c);
at least one light emission tip (66) disposed through a predetermined portion of the dome (62c), so as to emit light toward the wafer (63c) and receive light reflected by the wafer (63c);
nozzles (67,68), each of which is disposed around light emission tip (66) and through a predetermined portion of the dome (62c), so as to supply gases into the chamber (61c);
valves, which are provided each at each of the nozzles (67,68), so as to adjust quantity of the gases supplied into the chamber (61c); and
at least one state control section (100) including a light component extraction section (102), a proportional value estimation section (103), a comparison section (104), and a control section (106), the light component extraction section (102) extracting predetermined light components from among the light received through the light emission tip (66) and obtaining intensities of the extracted light components, the proportional value estimation section (103) estimating a proportional value between the intensities of the extracted light components, the comparison section (104) comparing the estimated proportional value with a reference value, the control section (106) controlling operations of the valves according to a compared result from the comparison section (104).

3. A plasma etching apparatus according to claim 2, wherein the first dome (62c) has a flatted outer surface and a curved inner surface facing an interior space of the chamber (61c), and a central portion of the curved inner surface bulges further than an edge portion thereof.

4. A plasma etching apparatus according to claim 1, 2 or 3, wherein the apparatus further comprises a second dome (62a,b,c) attached to the outer surface of the first dome (62a,b,c) and having a dielectric constant different from that of the first dome (62a,b,c).

5. A plasma etching apparatus according to claim 4, wherein the first dome (62a,b,c) has a dielectric constant smaller than that of the second dome (62a,b,c).

6. A plasma etching apparatus according to any of the preceding claims, wherein the coil (64a,b,c) has one of four-arm to eight-arm spiral shapes.

7. A plasma etching apparatus according to any of the preceding claims, wherein the light emission tip (66) has a concave lower end which prevents the light emission tip (66) from protruding beyond a lower surface of the dome (62a,b,c).

8. A plasma etching apparatus according to any of the preceding claims, wherein the light emission tip (66) is disposed through a central portion of the dome (62a,b,c).

9. A plasma etching apparatus according to any of the preceding claims, wherein the light emission tip (66) is disposed not only through a central portion but also through at least one edge portion of the dome (62a,b,c).

10. A plasma etching apparatus according to any of the preceding claims, further comprising a bias electric power supply section which applies bias electric power to a bottom of the chamber (61a,b,c).

11. A plasma etching method for manufacturing a semiconductor device, the method comprising:
extracting predetermined light components reflected by a wafer (63a,b,c) placed in a chamber (61a,b,c), and obtaining intensities of the extracted light components;
estimating a proportional value between the intensities of the extracted light components;
comparing the estimated proportional value with a reference value; and
controlling quantity of gases supplied into the chamber (61a,b,c) according a compared result.

12. A method according to claim 11, wherein the predetermined light component comprises CFx and SiOx components, the quantity of CF⁴ gas is increased when the estimated proportional value is larger than the reference value, and the quantity of O² gas is increased when the estimated proportional value is smaller than the reference value.

13. A plasma etching method for manufacturing a semiconductor device by means of a plasma etching apparatus, the plasma etching apparatus including a chamber (61a,b,c) in which a wafer (63a,b,c) is loaded and etched, a dome (62a,b,c) sealing an upper end of the chamber (61a,b,c), one selected from a four-arm to eight-arm spiral coil (64a,b,c)s placed on the dome (62a,b,c) and supplying electricity into the chamber (61a,b,c), and a bias electric power supply section applying bias electric power to a bottom of the chamber (61a,b,c), the method comprising:
supplying electric power, wherein a bias electric power having a magnitude of n is applied to the spiral coil (64a,b,c) while a bias electric power having a magnitude of m is applied to a bottom surface of the chamber (61a,b,c); and
generating a plasma, wherein the applied bias electric powers generate an electric field, thereby generating the plasma.

14. A method according to claim 13, wherein m/n has a value between 6 and 20.

15. A method according to claim 13 or 14, wherein n has a value between 90 and 100 Watts, and m has a value between 900 and 1000 Watts.

16. A method according to claim 13, 14 or 15, performed at a photoresist (PR) etching selectivity of x:1 where x is at least 6.

17. A method according to any of claims 13 to 16, performed at an etch rate ranging between 8000 and 9000 Å/min when the pressure in a chamber (61a,b,c) has a value between 40 and 80 mT and a bias electric power has a value of 1600 W.

18. A method according to any of claims 13 to 17, performed at a plasma density ranging between 4.40 × 10¹¹ cm⁻³ and 1.04 × 10¹² cm⁻³ when the pressure in the chamber (61a,b,c) has a value between 40 and 80 mT and the source electric power is 1000 W.

19. A method according to any of claims 13 to 18, performed at an electron particle temperature having a value not larger than 3.0 eV.

20. A method according to any of claims 13 to 19, performed at an ion current density having a value between 10 and 20 mA/cm² when the pressure in the chamber (61a,b,c) has a value between 40 and 80 mT and the source electric power is 1000 W.
